# FASCICULE DE BREVET EUROPEEN

(11) **EP 0 897 024 B1**
(45) Date de publication et mention de la délivrance du brevet: **11.02.2004**
(21) Numéro de dépôt: 98410085.9
(22) Date de dépôt: 28.07.1998
(51) Int. Cl.: C30B 25/02, H01L 21/205

(54) **Procédé d'épitaxie sur un substrat de silicium comprenant des zones fortement dopées à l'arsenic**
Epitaxieverfahren auf einem Siliciumsubstrat mit durch Arsen hochdotierten Gebieten
Process for epitaxy on a silicon substrate containing zones highly doped with arsenic

(30) Priorité: 31.07.1997 FR 9710032
(43) Date de publication de la demande: 17.02.1999
(73) Titulaire: STMicroelectronics S.A., 92120 Montrouge (FR); FRANCE TELECOM, 75015 Paris (FR)
(72) Inventeur: Dutartre, Didier, 38240 Meylan (FR); Jerier, Patrick, 38000 Grenoble (FR)
(74) Mandataire: de Beaumont, Michel

(56) Documents cités:
- FR-A- 2 041 710
- FR-A- 2 105 864
- US-A- 3 716 422
- US-A- 5 221 412
- PATENT ABSTRACTS OF JAPAN vol. 6, no. 211 (E-137), 23 octobre 1982 & JP 57 115822 A (NIPPON DENKI KK), 19 juillet 1982
- ISHII ET AL: "SILICON EPITAXIAL WAFER WITH ABRUPT INTERFACE BY TWO STEP EPITAXIAL GROWTH TECHNIQUE" JOURNAL OF THE ELECTROCHEMICAL SOCIETY., vol. 122, no. 11, novembre 1975, pages 1523-1531, XP002062227 MANCHESTER, NEW HAMPSHIRE US
- PATENT ABSTRACTS OF JAPAN vol. 7, no. 46 (C-153), 23 février 1983 & JP 57 196800 A (NIPPON DENKI KK)

## Description

La présente invention concerne la fabrication des composants semiconducteurs et plus particulièrement le dépôt par épitaxie d'une couche de silicium sur un substrat de silicium monocristallin.

De façon générale, dans le domaine de la fabrication des composants semiconducteurs, il est connu de faire croître des couches épitaxiées d'un type de conductivité et d'un niveau de dopage déterminés sur des substrats d'un type de conductivité déterminé, généralement différent de celui de la couche épitaxiée, et d'un niveau de dopage déterminé. L'épitaxie permet d'obtenir des couches minces monocristallines dont le niveau de dopage est constant sur leur épaisseur, contrairement aux procédés impliquant une étape de diffusion de dopants, dans lesquels le niveau de dopage décroît avec la profondeur de diffusion.

Les procédés d'épitaxie en phase gazeuse, développés depuis de nombreuses années, fonctionnent de façon tout à fait satisfaisante quand le niveau de dopage du substrat est homogène et relativement faible. Par contre, dans les technologies modernes, on utilise de plus en plus des couches enterrées, c'est-à-dire des couches localisées fortement dopées du premier et/ou du second type de conductivité formées sous la couche épitaxiée. Ces couches enterrées sont obtenues en réalisant d'abord une implantation à dose élevée d'un dopant choisi dans le substrat avant de réaliser la croissance épitaxiale. Ces couches sont par exemple destinées à former des collecteurs de transistors bipolaires et doivent être très fortement dopées. Il en résulte un inconvénient connu, couramment désigné par le terme autodopage, qui est que le dopant implanté tend, lors du procédé d'épitaxie, à doper la couche épitaxiée au-dessus et à côté de la région implantée. La couche épitaxiée n'a alors plus la résistivité souhaitée. Cet inconvénient est d'autant plus marqué que la couche épitaxiée est mince puisque le phénomène d'autodopage se produit essentiellement pendant la phase initiale de croissance de cette couche. En outre, il apparaît à l'évidence que le taux d'autodopage de la couche épitaxiée dépend de la surface des zones dopées destinées à devenir des couches enterrées. Plus cette surface est importante, plus l'autodopage est important. Ainsi, d'un circuit à l'autre, selon que l'on a réalisé plus ou moins de couches enterrées, la couche épitaxiée n'aura pas la même résistivité d'ensemble. Ce phénomène est difficilement maîtrisable. Ceci s'oppose à ce que l'on recherche dans tout procédé industriel, à savoir obtenir des résultats contrôlés et répétables, et si possible identiques pour différents produits d'une technologie donnée.

A ce jour, de nombreuses solutions ont été proposées pour tenter de résoudre les problèmes d'autodopage et plus particulièrement diminuer l'autodopage par de l'arsenic sans augmenter l'autodopage par du bore lors du dépôt d'une couche épitaxiale faiblement dopée sur un substrat contenant des zones implantées à l'arsenic et des zones implantées au bore.

On a notamment proposé de réduire la pression dans le réacteur d'épitaxie, d'augmenter la durée de certaines étapes thermiques, notamment celle du recuit avant l'épitaxie proprement dite, de choisir des conditions de pression propres à réduire la vitesse de croissance... Ces procédés ont donné des résultats plus ou moins satisfaisants selon les conditions de fonctionnement et aucun n'a recueilli à ce jour un consensus général.

On a également proposé de procéder à une épitaxie en plusieurs étapes mais aucune solution satisfaisante n'a été fournie et un tel procédé n'est pas utilisé industriellement. Ceci est sans doute dû au fait que, lors d'une épitaxie, il faut régler et optimiser un très grand nombre de paramètres parmi lesquels on peut citer la pression, la température, la durée de chacune des étapes, les décalages entre étapes, les compositions des gaz, etc.

L'article de Ishii et al. paru dans "Journal of the Electrochemical Society", vol.122, N°11 en novembre 1975, pages 1523-1531, décrit un procédé dans lequel on procède à deux épitaxies successives à une même température.

En outre, si certaines solutions proposées ont permis de réduire l'autodopage dû à l'arsenic, elles ont empiré l'autodopage dû à d'autres dopants tels que le bore et le résultat global n'a donc pas été satisfaisant.

Ainsi, la présente invention vise un procédé de dépôt épitaxial de silicium sur un substrat de silicium dans lequel sont implantés au préalable divers dopants à des taux de concentration élevés dans le but de former des couches enterrées, et notamment d'arsenic et de bore.

Pour atteindre cet objet, la présente invention prévoit un procédé de dépôt par épitaxie en phase gazeuse de silicium sur un substrat de silicium comprenant des zones contenant des dopants à forte concentration dont de l'arsenic, en évitant un autodopage de la couche épitaxiée par l'arsenic, comprenant les étapes consistant à a) procéder à un premier dépôt épitaxial mince (t₅-t₆) à une première température de l'ordre de 1100°C ; b) procéder à un recuit (t₆-t₃) ; les conditions et la durée du premier dépôt épitaxial et du recuit étant telles que la longueur de diffusion de l'arsenic soit nettement inférieure à l'épaisseur de la couche formée lors du premier dépôt ; et c) procéder à un deuxième dépôt épitaxial (t₃-t₄) à une deuxième température, inférieure à la première température, de l'ordre de 1050°C, et pendant une durée choisie pour obtenir une épaisseur totale souhaitée.

Selon un mode de réalisation de la présente invention, le premier dépôt épitaxial est précédé d'une étape initiale de recuit.

Selon un mode de réalisation de la présente invention, le premier dépôt est poursuivi pendant une durée suffisante pour obtenir une épaisseur de l'ordre de 40 à 60 nanomètres.

Selon un mode de réalisation de la présente invention, les étapes de recuit sans formation d'épitaxie sont réalisées en présence d'hydrogène.

Selon un mode de réalisation de la présente invention, pendant les étapes a) et b), les paramètres de fonctionnement du réacteur d'épitaxie sont choisis en dehors des plages usuelles imposées pour une croissance épitaxiale homogène.

Selon un mode de réalisation de la présente invention, le débit de gaz porteur est augmenté par rapport aux conditions usuelles.

Selon un mode de réalisation de la présente invention, les dépôts épitaxiaux sont réalisés en présence d'une source d'arsenic.

Selon un mode de réalisation de la présente invention, l'étape b) est réalisée en présence d'une source d'arsenic.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 illustrent schématiquement un procédé d'épitaxie avec formation de couches enterrées ;
la figure 3 illustre un procédé d'épitaxie selon l'art antérieur ;
là figure 4 illustre un procédé d'épitaxie selon la présente invention ;
la figure 5A est une vue de dessus d'une plaquette de test et la figure 5B illustre des résultats comparés d'autodopage à l'arsenic dans des couches épitaxiées formées selon un procédé classique et selon le procédé de l'invention ;
les figures 6A et 6B illustrent schématiquement une explication possible de l'autodopage par l'arsenic dans le procédé antérieur ; et
les figures 7A et 7B illustrent schématiquement une explication possible de la réduction de l'autodopage par le procédé selon la présente invention.

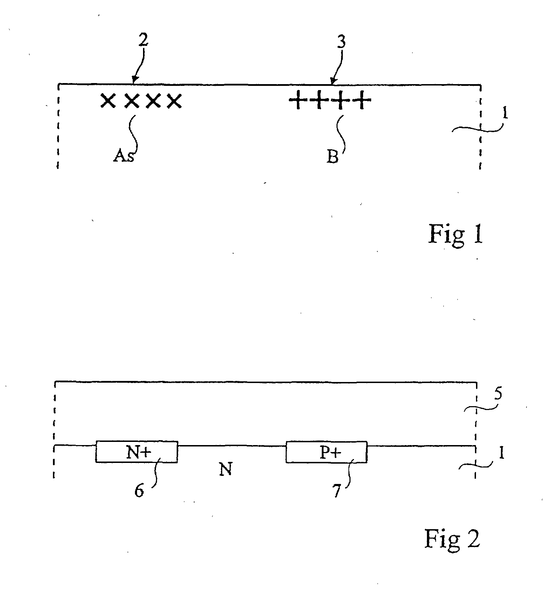

De façon classique, pour former une couche épitaxiée sur un substrat de silicium monocristallin 1, comme le représente la figure 1, on commence par former dans le substrat 1 des zones 2 et 3 dans lesquelles sont réalisées des implantations à forte dose de dopants destinées à constituer des couches enterrées. Dans l'exemple représenté, la zone 2 contient de l'arsenic et la zone 3 du bore.

Ensuite, comme le représente la figure 2, on développe par épitaxie une couche de silicium monocristallin 5 et les régions 2 et 3 correspondent alors respectivement à des couches enterrées 6 et 7. La croissance épitaxiale s'effectue par exemple sous faible pression en présence d'hydrogène et d'un composé du silicium tel que le dichlorosilane ou le trichlorosilane et en présence d'un composé d'un dopant, par exemple de la phosphine pour former une couche de type N dopée au phosphore. Le problème posé est que le dopage de la couche épitaxiée est influencé par les exodiffusions en provenance des couches enterrées.

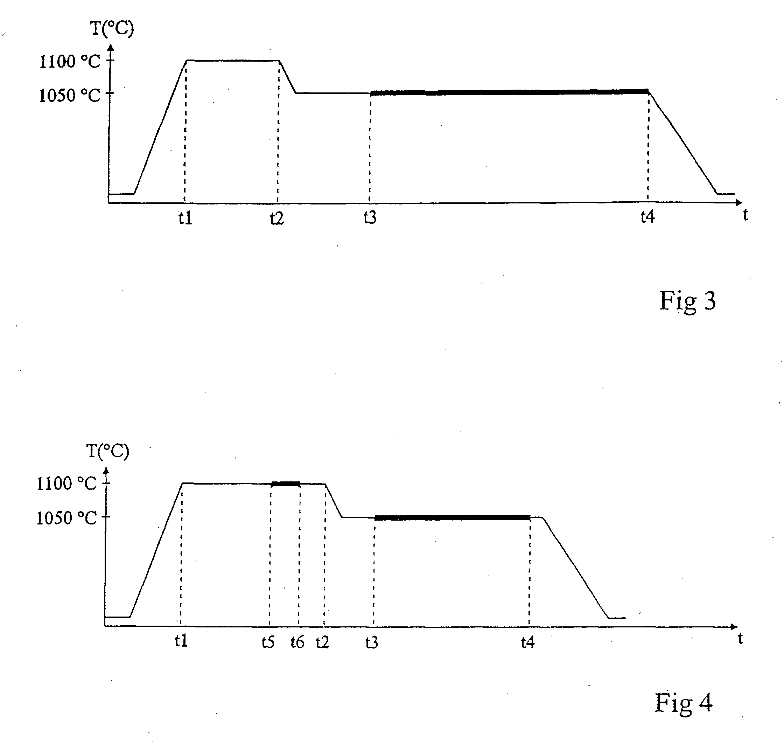

La figure 3 illustre une séquence thermique classique, à deux paliers de température, utilisée lors d'une épitaxie. On commence à monter en température dans un réacteur d'épitaxie, pour atteindre à un instant t₁ une température désirée, généralement plus élevée que la température prévue pour le dépôt, par exemple 1100°C, en présence d'hydrogène à faible pression, par exemple 60 torrs (environ 10⁴ Pa). On maintient la température pendant une certaine durée, jusqu'à un instant t₂, après quoi on descend à la température choisie pour le dépôt épitaxial, par exemple 1050°C, et on attend que la température se stabilise jusqu'à un instant t₃, puis on procède au dépôt proprement dit en présence d'hydrogène et par exemple de dichlorosilane jusqu'à un instant t₄. La durée t₃-t₄ est choisie, en fonction des pressions partielles des gaz, pour obtenir un dépôt d'épaisseur choisie. Après quoi, on redescend en température à un rythme également déterminé. On trouvera dans la littérature de nombreuses descriptions d'un tel procédé.

La figure 4 illustre un exemple de séquence thermique selon la présente invention. On notera qu'il ne s'agit que d'un exemple et on indiquera ci-après des règles générales d'où l'on peut tirer diverses variantes de réalisation de la présente invention. Comme dans le cas de la figure 3, cette séquence comporte deux paliers à température élevée, par exemple 1100°C et 1050°C. Selon la présente invention, pendant le palier à la première température, entre des instants t₅ et t₆, on procède à une phase de croissance épitaxiale limitée, par exemple pour obtenir une couche d'une épaisseur de 40 à 60 nm. Après cela, on prévoit un premier temps d'attente à température haute entre les instants t₆ et t₂ et un deuxième temps d'attente à une température plus basse entre les instants t₂ et t₃. Comme on le verra ci-après, la prévision de ces temps d'attente est une caractéristique essentielle de la présente invention. Ensuite, entre les instants t₃ et t₄, on procède à une épitaxie, par exemple dans les mêmes conditions que celles illustrées précédemment mais pendant une durée plus faible puisqu'une portion de la couche épitaxiale a déjà été formée.

A titre d'exemple numérique, la durée de recuit initial entre les instants t₁ et t₅ peut être de 60 secondes, la durée de dépôt entre les instants t₅ et t₆ de l'ordre de 15 secondes, et la durée d'attente entre les instants t₆ et t₃ de l'ordre de 30 secondes. La durée de dépôt entre les instants t₃ et t₄, supérieure à la minute, est choisie en fonction de l'épaisseur de la couche épitaxiée à faire croître.

La durée t₅-t₆, la durée t₆-t₃ et l'épaisseur de la couche épitaxiée formée entre les instants t₅ et t₆ sont telles que l'épaisseur de la couche épitaxiée est supérieure à la longueur de diffusion de l'arsenic pendant la durée t₅-t₃. On définit la longueur de diffusion comme la distance moyenne dont diffusent des atomes d'arsenic pendant une durée donnée dans des conditions de température donnée. Pour les durées indiquées ci-dessus à titre d'exemple, la longueur de diffusion de l'arsenic pendant la durée t₅-t₆ à 1100°C est de l'ordre de 20 nm et la distance de diffusion pendant la durée t₆-t₃, dont l'essentiel est réalisé à une température plus faible, est également de l'ordre de 20 nm. Ainsi, la longueur totale de diffusion est inférieure à l'épaisseur de la couche formée qui, rappelons-le, est de l'ordre de 40 à 60 nm.

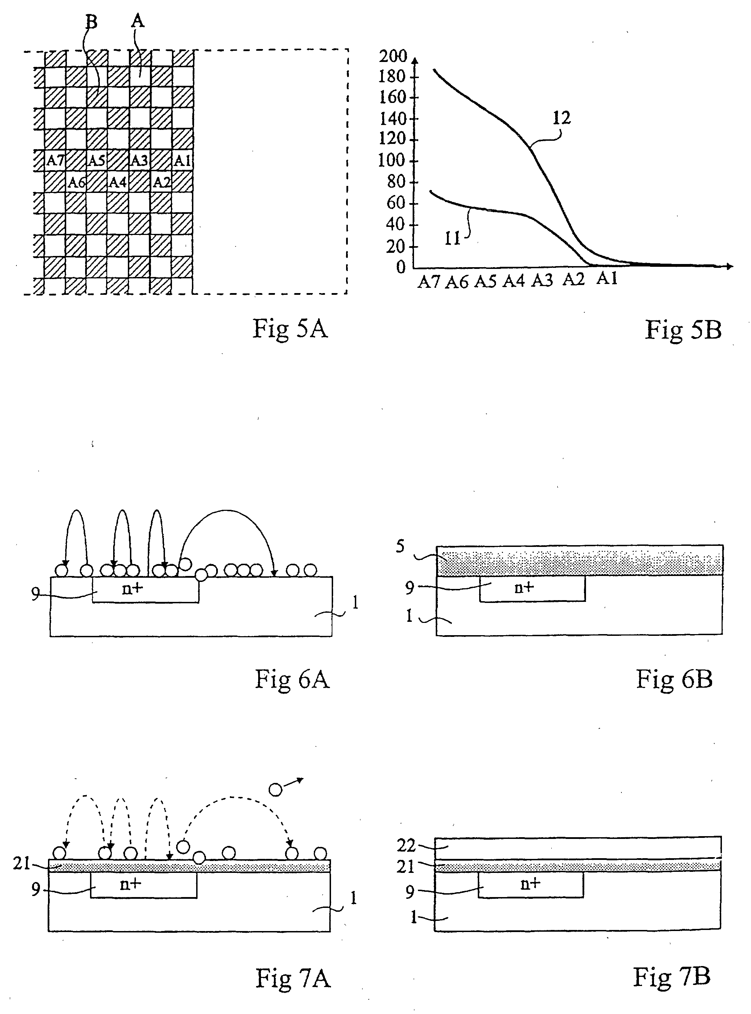

La figure 5A est une vue de dessus d'une plaquette de test réalisée spécialement pour analyser l'efficacité du procédé selon la présente invention. Avant l'épitaxie, la plaquette est divisée en deux parties, une première partie, à droite dans la figure, où aucune implantation n'est réalisée, et une deuxième partie, à gauche dans la figure où est réalisé un damier de zones A, non implantées, et de zones B ayant subi une forte implantation d'arsenic. On désigne par A1 à A7 des "cases" non-implantées du damier s'étendant à partir de la limite entre les parties droite et gauche de la figure. Dans un exemple de réalisation, chaque case du damier a une dimension de 10 x 10 mm.

La figure 5B illustre des résultats comparés d'autodopage à l'arsenic dans des couches épitaxiées formées selon un procédé classique et selon le procédé de l'invention au-dessus de la plaquette de la figure 5A. On compare les résistivités mesurées à partir de la surface de la plaquette au-dessus de zones non-implantées. Il est clair que l'influence des zones implantées augmente quand on se déplace de la case A1 vers la case A7.

On constate que la variation de conductivité, en µΩ⁻¹, est beaucoup plus faible avec le procédé selon la présente invention (courbe 11) qu'avec le procédé classique (courbe 12). Des mesures similaires effectuées avec une plaquette de test semblable à celle de la figure 5A, mais dans laquelle les zones dopées ont subi une implantation de bore, n'ont pas montré de différence nette entre le procédé classique et le procédé selon l'invention.

Ainsi, le résultat visé est obtenu, à savoir que l'autodopage par l'arsenic est réduit tandis que l'autodopage par le bore n'est pas dégradé.

On va donner maintenant une explication des phénomènes qui conduisent à ce résultat de l'avis actuel des inventeurs. Il sera toutefois clair que, même si cette explication théorique s'avère erronée ou incomplète, ceci ne saurait affecter la portée de l'invention dont les résultats ont été démontrés.

La figure 6A représente schématiquement un substrat 1 dans lequel on a implanté des atomes d'arsenic 2. La demanderesse considère que dès le début d'un chauffage, des atomes d'arsenic existent à la surface du substrat en une couche très mince, sensiblement monoatomique. Au cours de l'épitaxie, cette couche de surface demeure à la surface de la couche épitaxiée en cours de croissance ; elle constitue ainsi en permanence une source de dopage d'arsenic. Ainsi, comme le représente la figure 6B, on obtient finalement des atomes d'arsenic répartis sur toute l'épaisseur de la couche épitaxiée 5 selon un profil décroissant de l'interface vers la surface.

Par contre, selon la présente invention, comme le représente la figure 7A, une fois que la première couche épitaxiée 21 résultant du premier dépôt entre les instants t₅ et t₆ est formée, la période de chauffage entre les instants t₆ et t₃ permet aux atomes superficiels d'arsenic d'être en grande partie éliminés et la concentration en surface atteint une valeur très faible. Ainsi, quand l'on procède à la deuxième étape d'épitaxie entre les instants t₃ et t₄, il n'y a pratiquement plus de source d'atomes d'arsenic puisque ceux provenant de la couche enterrée elle-même ne progressent pas suffisamment par diffusion pour polluer la couche formée, 22, comme le représente la figure 7B.

Ainsi, le procédé en deux temps selon la présente invention permet de réduire considérablement l'autodopage et de le limiter à la partie inférieure de la couche épitaxiée, à condition que l'épaisseur de la couche épitaxiée 21 formée à la première étape forme barrière à la diffusion de l'arsenic jusqu'à sa surface avant le début de la deuxième étape d'épitaxie, la première portion de la couche épitaxiée ayant une épaisseur faible devant l'épaisseur totale de la couche épitaxiée 21-22.

En outre, un avantage de la présente invention est que lors des étapes préliminaires, avant la deuxième phase de dépôt épitaxial (entre les instants t₃ et t₄), les divers paramètres de fonctionnement peuvent être assez librement choisis. En effet, la couche formée pendant la première phase d'épitaxie est très mince et son uniformité n'est pas critique. Ceci se distingue des contraintes généralement imposées pour l'utilisation d'un réacteur d'épitaxie. Ces contraintes (fenêtre de procédé) sont très strictes si l'on veut maintenir un dépôt épitaxial uniforme. En particulier, pendant les étapes préliminaires, on pourra augmenter notablement le débit (flux/pression) de gaz porteur (généralement H₂) pour améliorer le balayage en surface de l'arsenic.

Bien entendu, la présente invention est susceptible de diverses variantes et modifications qui apparaîtront à l'homme de l'art. Par exemple, si l'on veut que le nouveau processus reste aussi compatible que possible avec les procédés antérieurs, on pourra prévoir un dopage volontaire à l'arsenic des couches épitaxiales formées, de sorte que ces couches aient sensiblement le même comportement que les couches épitaxiales antérieures formées en une seule étape. Toutefois, on aura alors l'avantage que ce dopage sera parfaitement contrôlé et ne variera pas sur la surface de la puce. Ce dopage à l'arsenic peut résulter d'une addition d'arsine à la phosphine généralement utilisée. Une atmosphère contenant de l'arsine peut notamment être prévue entre les instants t₂ et t₃ et notamment peu avant l'instant t₃.

## Revendications

1. Procédé de dépôt par épitaxie en phase gazeuse de silicium sur un substrat de silicium (1) comprenant des zones (2, 3) contenant des dopants à forte concentration dont de l'arsenic, en évitant un autodopage de la couche épitaxiée par l'arsenic, **caractérisé en ce qu'**il comprend les étapes suivantes :
a) procéder à un premier dépôt épitaxial mince (t₅-t₆) à une première température de l'ordre de 1100°C ;
b) procéder à un recuit (t₆-t₃) ; les conditions et la durée du premier dépôt épitaxial et du recuit étant telles que la longueur de diffusion de l'arsenic soit nettement inférieure à l'épaisseur de la couche formée lors du premier dépôt ;
c) procéder à un deuxième dépôt épitaxial (t₃-t₄) à une deuxième température, inférieure à la première température, de l'ordre de 1050°C, et pendant une durée choisie pour obtenir une épaisseur totale souhaitée.

2. Procédé selon la revendication 1, **caractérisé en ce que** le premier dépôt épitaxial est précédé d'une étape initiale de recuit.

3. Procédé selon la revendication 1, **caractérisé en ce que** le premier dépôt est poursuivi pendant une durée suffisante pour obtenir une épaisseur de l'ordre de 40 à 60 nanomètres.

4. Procédé selon l'une quelconque des revendications précédentes, **caractérisé en ce que** les étapes de recuit sans formation d'épitaxie sont réalisées en présence d'hydrogène.

5. Procédé selon l'une quelconque des revendications précédentes, **caractérisé en ce que**, pendant les étapes a) et b), les paramètres de fonctionnement du réacteur d'épitaxie sont choisis en dehors des plages usuelles imposées pour une croissance épitaxiale homogène.

6. Procédé selon la revendication 5, **caractérisé en ce que** le débit de gaz porteur est augmenté par rapport aux conditions usuelles.

7. Procédé selon l'une quelconque des revendications 1 à 4, **caractérisé en ce que** les dépôts épitaxiaux sont réalisés en présence d'une source d'arsenic.

8. Procédé selon l'une quelconque des revendications 1 à 4, **caractérisé en ce que** l'étape b) est réalisée en présence d'une source d'arsenic.

## Claims

1. A method of vapor phase epitaxial deposition of silicon on a silicon substrate (1) including areas (2, 3) containing dopants at high concentration among which is arsenic, while avoiding an autodoping of the epitaxial layer by arsenic, **characterized in that** it includes the steps of:
a) performing a first thin epitaxial deposition (t₅-t₆) at a first temperature on the order of 1100°C;
b) performing an anneal (t₆-t₃);
the conditions and the duration of the first epitaxial deposition and of the anneal being such that the arsenic diffusion length is much lower than the thickness of the layer formed during the first deposition; and
c) performing a second epitaxial deposition (t₃-t₄) at a second temperature, lower than the first temperature, on the order of 1050°C, and for a chosen duration to obtain a desired total thickness.

2. The method of claim 1, **characterized in that** the first epitaxial deposition is preceded by an initial anneal step.

3. The method of claim 1, **characterized in that** the first deposition is pursued for a duration sufficient to obtain a thickness on the order of 40 to 60 nanometers.

4. The method of any of the preceding claims, **characterized in that** the steps of anneal without epitaxy are performed in the presence of hydrogen.

5. The method of any of the preceding claims, **characterized in that**, during steps a) and b), the operating parameters of the epitaxy reactor are chosen to be outside the usual ranges imposed for a homogenous epitaxial growth.

6. The method of claim 5, **characterized in that** the flow of carrier gas is increased with respect to usual conditions.

7. The method of any of claims 1 to 4, **characterized in that** the epitaxial depositions are performed in the presence of an arsenic source.

8. The method of any of claims 1 to 4, **characterized in that** step b) is performed in the presence of an arsenic source.

## Patentansprüche

1. Ein Verfahren zur Dampfphasenepitaxialabscheidung von Silizium auf einem Siliziumsubstrat (1) mit Bereichen (2, 3), die Dotiersubstanzen mit hoher Konzentration enthalten, unter denen Arsen enthalten ist, während eine automatische Dotierung der Epitaxialschicht durch Arsen verhindert wird, **dadurch gekennzeichnet, dass** das Verfahren die folgenden Schritte aufweist:
a) Durchführen einer ersten dünnen Epitaxialabscheidung (t₅-t₆) mit einer ersten Temperatur in der Größenordnung von 1.100°C;
b) Durchführen einer Wärmebehandlung bzw. eines Anneals (t₆-t₃);
wobei die Bedingungen und die Zeitdauer der ersten Epitaxialabscheidung und des Anneals derart gewählt sind dass die Arsendiffusionslänge viel geringer ist als die Dicke der Schicht, die während der ersten Abscheidung gebildet wurde; und
c) Durchführen einer zweiten Epitaxialabscheidung (t₃-t₄) mit einer zweiten Temperatur, die niedriger ist als die erste Temperatur und zwar in der Größenordnung von 1.050°C und für eine ausgewählte Dauer zum Erhalten einer gewünschten Gesamtdicke.

2. Verfahren nach Anspruch 1, **dadurch gekennzeichnet, dass** vor der ersten Epitaxialabscheidung ein anfänglicher Annealschritt vorgesehen ist.

3. Verfahren nach Anspruch 1, **dadurch gekennzeichnet, dass** die erste Abscheidung für eine Dauer durchgeführt, die ausreicht, um eine Dicke in einer Größenordnung von 40 bis 60 Nanometer zu erreichen.

4. Verfahren nach einem der vorhergehenden Ansprüche, **dadurch gekennzeichnet, dass** die Annealschritte ohne Expitaxy in der Gegenwart von Wasserstoff durchgeführt werden.

5. Verfahren nach einem der vorhergehenden Ansprüche, **dadurch gekennzeichnet, dass** während der Schritte a) und b) die Betriebsparameter des Epitaxyreaktors derart gewählt werden, dass sie außerhalb der üblichen Bereiche liegen, die für ein homogenes Epitaxialwachstum angelegt werden.

6. Verfahren nach Anspruch 5, **dadurch gekennzeichnet, dass** die Strömung eines Träger- bzw. Carriergases bezüglich der üblichen Bedingungen erhöht wird.

7. Verfahren nach einem der Ansprüche 1 bis 4, **dadurch gekennzeichnet, dass** die Epitaxialabscheidungen in der Gegenwart einer Arsenquelle durchgeführt werden.

8. Verfahren nach einem der Ansprüche 1 bis 4, **dadurch gekennzeichnet, dass** der Schritt b) in der Gegenwart einer Arsenquelle durchgeführt wird.
